# EUROPEAN PATENT APPLICATION

(11) **EP 0 633 111 A2**
(43) Date of publication of application: **11.01.1995**
(21) Application number: 94202389.6
(22) Date of filing: 24.11.1989
(51) Int. Cl.: B29C 33/22, B29C 33/24, B29C 45/02, B29C 70/72

(54) **Single-strip moulding apparatus with movable mould halves**

(62) Divisional of application: 89203003.2
(71) Applicant: FICO B.V., NL-6914 AD Herwen (NL)
(72) Inventor: Venrooij, Johannes Lambertus Gerardus Maria, NL-6921 KG Duiven (NL); Verwoerd, Wouter Bastiaan, NL-6581 RK Malden (NL)
(74) Representative: Hoijtink, Reinoud

(57) **Abstract**

Electronic components, chips, are moulded in a single-strip moulding apparatus. The products to be moulded are placed in a mould consisting of two halves, one of the halves whereof displays recesses for receiving a component, which half is connected via a channel with a cavity for receiving a quantity of moulding material. The mould halves are closed relative to one another by an angle lever system.

## Description

For the moulding of electronic components, chips, moulding apparatus are used wherein a so-called leadframe is placed into a mould wherein the mould displays recesses for receiving the parts for moulding, and in addition cavities are arranged in the mould wherein measured quantities of moulding material are placed and wherein by supplying heat and exerting pressure in these cavities the moulding material becomes liquid, moves via channels intended for that purpose to the parts for moulding and, curing there, encapsulates the leadframe. The leadframe is subsequently removed from the moulding apparatus and subjected to further processing.

The object of the invention is to provide a single-strip moulding apparatus which combines a simple construction with a relatively high production rate.

This is achieved according to the invention by providing a single-strip moulding apparatus comprising a mould die formed by two mould halves movable relative to one another and closable onto one another, means for placing a leadframe into one of the mould halves, means for carrying moulding material into cavities of the mould, means for exerting pressure in these cavities, means for heating the mould halves, means for cleaning the mould halves and means for removing a moulded product from the mould, wherein the mould halves are closed relative to one another by an angle lever system connected to one of the mould halves and driven by an electromotor and a screwed rod. The required closing force to be exerted on the mould halves is transmitted in a suitable manner by the angle lever system since this exerts great force especially at the end of the stroke.

As first alternative embodiment the mould halves can be moved relative to one another using a control mechanism consisting of a pneumatic cylinder which effects the largest part of the stroke and a piston-cylinder unit having multiple pistons placed on the piston rod for providing by pneumatic means the final necessary closing force.

As second alternative embodiment the mould halves can be moved relative to one another using a control mechanism consisting of at least one pneumatic cylinder which effects the largest part of the stroke and a closed piston-diaphragm cylinder unit filled with liquid for converting pneumatic pressure into hydraulic pressure for providing the final necessary closing force.

The invention will be further elucidated with reference to the drawings.

In the drawings:
figures 1-3 show schematically one complete cycle of the moulding apparatus according to the invention;
figure 4 shows a perspective view of the moulding apparatus according to the invention;
figure 5 shows on a larger scale a detail of the lowermost part of the moulding apparatus according to figure 4;
figure 6 shows a sectional view of the mould of the moulding apparatus from figures 4 and 5;
figure 7 shows a first alternative embodiment of the closing mechanism of the mould of the moulding apparatus according to the invention; and
figure 8 shows a second alternative embodiment of the closing mechanism of the mould of the moulding apparatus according to the invention.

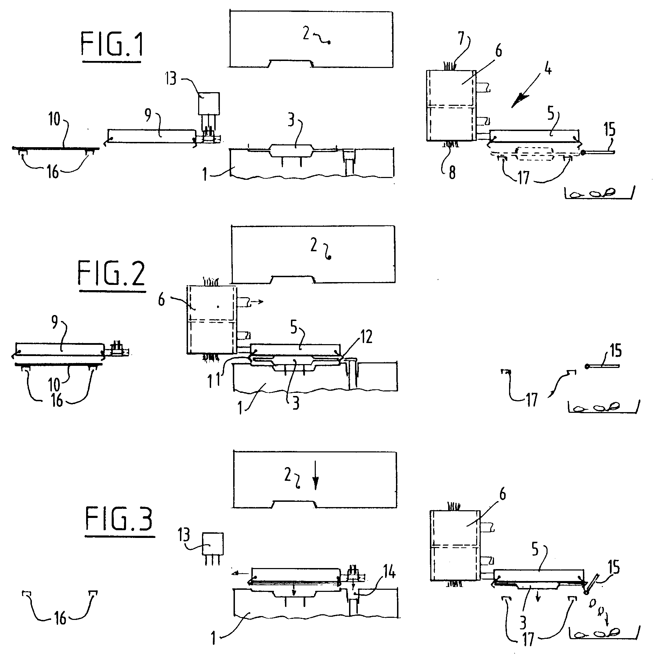

In figure 1 the mould, which consists of a fixedly positioned lower half and a vertically movable upper half, is open. It is assumed that the moulding has been completed during the previous cycle and that the moulded product 3 is still in the mould, that is, in the lower half 1. The cleaning-discharge unit 4 consists of a discharge carriage 5 and a brushing device 6 with brushes at the top 7 and brushes at the bottom 8. After opening of the mould (figure 1) the cleaning-discharge carriage 4 performs a movement to the left and thereby cleans the upper half of the mould (figure 2). The input carriage 9 likewise moves to the left to pick up a subsequent leadframe 10 from a store (not drawn) by means of a feed belt 16.

According to figure 2 the cleaning-discharge unit 4 then performs the return stroke wherein the discharge carriage 5 picks up the finished moulded frame 3 using schematically designated hook-shaped means 11, 12 and cleans the lower half of the mould.

Following on from the active stroke shown in figure 2 the input carriage 9 places the next leadframe into the mould. During the position in figure 1 the input carriage is thereby filled in cavities arranged for this purpose from a so-called pellet carriage 13 with pellet-shaped portions of moulding material which in the position as in figure 3 are placed into the cavities 14 intended for this purpose in the lower half 1 of the mould. The upper half 2 of the mould subsequently moves in the downward direction indicated with an arrow and closes (not drawn) onto the lower mould half, whereupon the moulding process begins. In the position drawn in figure 3 remnants of the moulding pellets are removed from the leadframe 3 with schematically designated means 15, after which the leadframe is discharged via a belt 17.

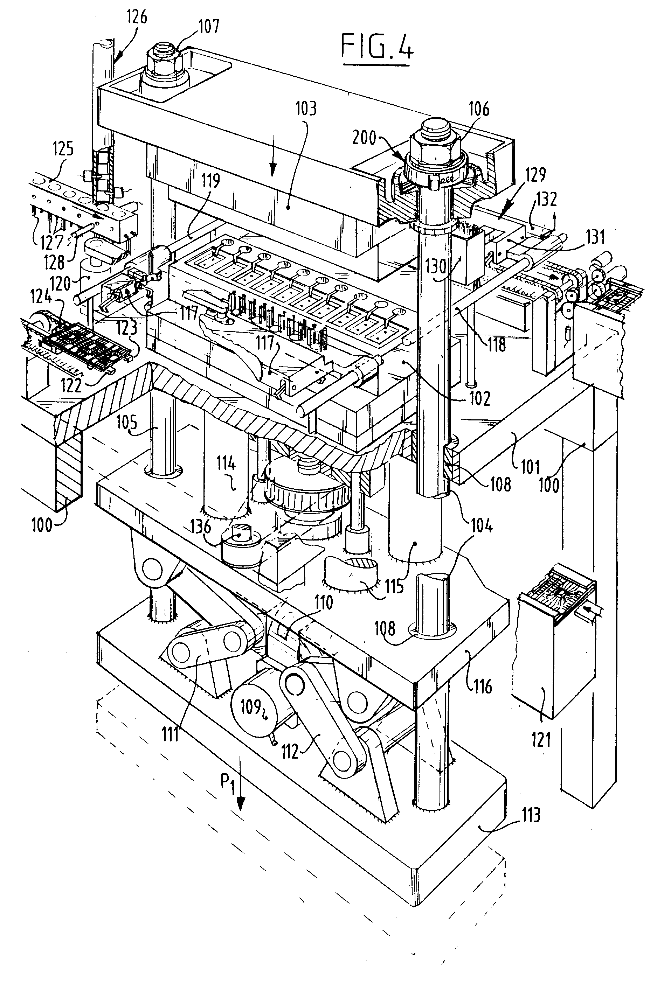

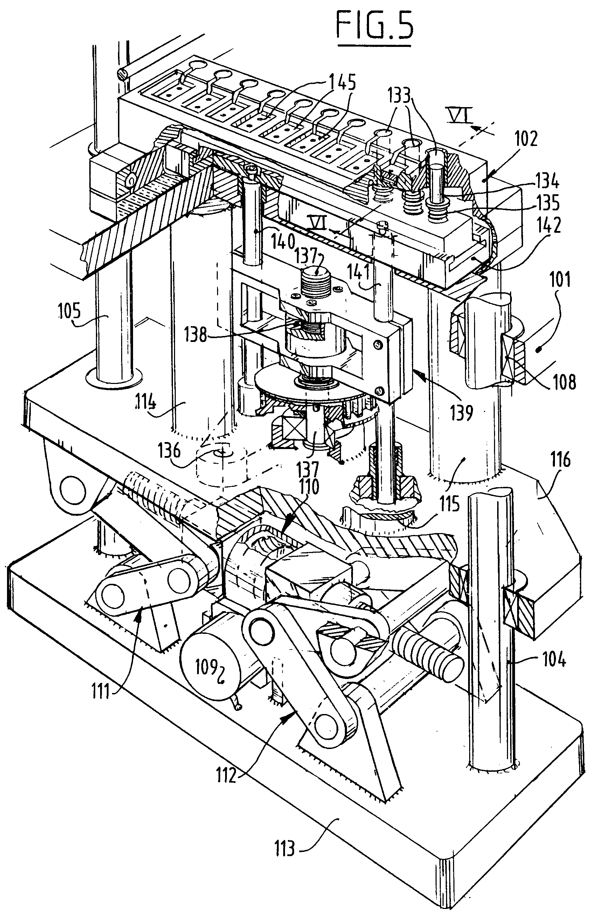

A further more detailed description will now be given with reference to figures 4 and 5.

Mounted on the frame 100 of the machine is a fixedly positioned table 101. The table 101 bears a fixed lower mould half 102. The upper mould half 103 is movable relative to the lower half 102 using pull rods 104, 105 which are connected to the upper half 103 by the respective nut connections, 106, 107. The pull rods 104, 105 are movable relative to the fixed table 101 via bearings, for example 108.

The driving of the upper half of the mould 103 takes place from an electromotor 109. Driven by means of the worm box 110 are the angle lever systems 111, 112. The angle lever systems are coupled on the one side to a movable underplate 113 and on the other side to a plate 116 fixedly connected to the table 101 by means of columns 114, 115. When the electromotor rotates the underplate 113 is moved vertically, for example in the direction of the arrow P1, which movement is transmitted via the pull rods 104, 105 onto the upper mould half 103. At the end of the stroke the arms of the angle lever system 111, 112 lie practically in one line so that a very great closing force is achieved.

The input carriage 117 is movable over the guide rails 118, 119. The driving of the input carriage 117 takes place from the electromotor 120.

Leadframes are supplied from a supply cassette and are carried up over the belts 122, 123 as far as a stop 124. During the position of the input carriage outside the mould the input carriage is filled from a so-called pellet-filling carriage 125 with pellet-shaped moulding material which is taken from a supply reservoir 126. For a reliable take-over of pellet-shaped moulding material by the input carriage 117 from the pellet transporting carriage 125 use is made in both carriages of pin-shaped guiding means 127. The mutual movements are controlled using a sensor 128.

The cleaning-discharge unit 129 is likewise movable over the rails 118, 119 between the position outside the mould die and the position inside the mould die. The unit 129 consists of a cleaning-brushing device 130 and a discharge member 131. The cleaning device 130 brushes both mould halves after use and simultaneously sucks up brushed-off remnants. Co-acting with the unit is a break-off plate 132 which subjects the finished product to an after-processing.

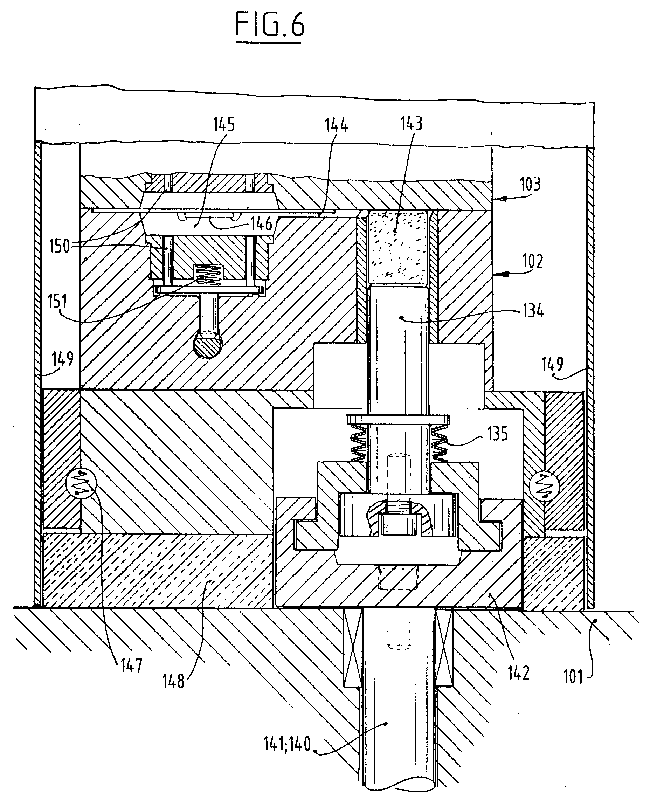

As can be seen in figure 5, the cavities 133 in the lower half 102 of the mould are each provided with a plunger 134 which (see also figure 6) is biased by a spring washer 135 such that the position of the plunger is adapted to the quantity of moulding material in the relevant cavities 133. The plungers are driven from an electromotor which drives a screwed rod 137 via the speed control 136. A nut 138 is placed on the screwed rod so that the rotating movement is converted into a vertically directed movement of the frame 139. Fixedly coupled to the frame are the drive rods 140, 141 for the plunger bracket 142 which in turn drives the plungers. As can be seen from the section VI-VI in figure 5 shown on a larger scale in figure 6, the pellet-shaped moulding material 143 is compressed during the ascending movement and transported via the channel 144 to the cavity 145 in the lower half of the mould where the chip 146 is arranged. As can be further seen in figure 6 a heating coil 147 is arranged for heating the lower half of the mould. The lower half of the mould is insulated by means of insulating material 148. Also visible in figure 6 is the protective cover 149.

In order to improve removal of the finished product a push-out pin 150 under bias of a spring 151 is arranged near the cavity 145.

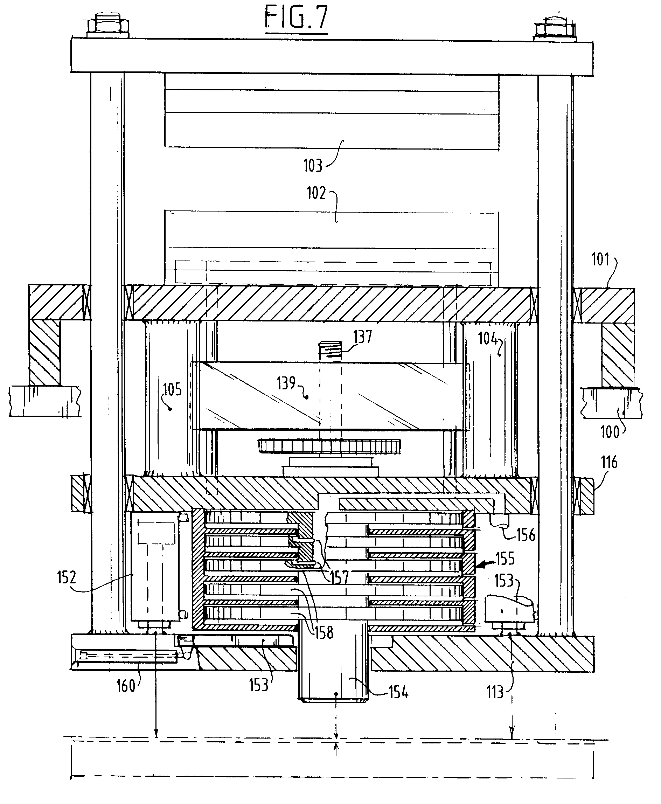

The embodiment according to figure 7 shows another embodiment for displacement of the upper half of the mould and the generating of the required great closing force.

Pneumatic cylinders 152 and 153 displace the upper half of the mould via the movable underplate 113, as in the case of the first discussed embodiment. At the end of the stroke the slide 153 is pushed under the piston rod 154 so that a closed piston-plunger 155 is created. Via the channel compressed air is subsequently admitted from a source 156 (not drawn) which is distributed via the sub-channels, for example 157, over pistons, for example 158, arranged on the piston rod 154. As a result of the large suction surface obtained by the combination of the pistons 158 arranged parallel on the rod 154 a very great closing force is achieved with a small stroke. This is transmitted to the plate 113 and therefore to the upper half of the mould 103. It is further noted that the closing of the slide takes place by means of the plunger 160.

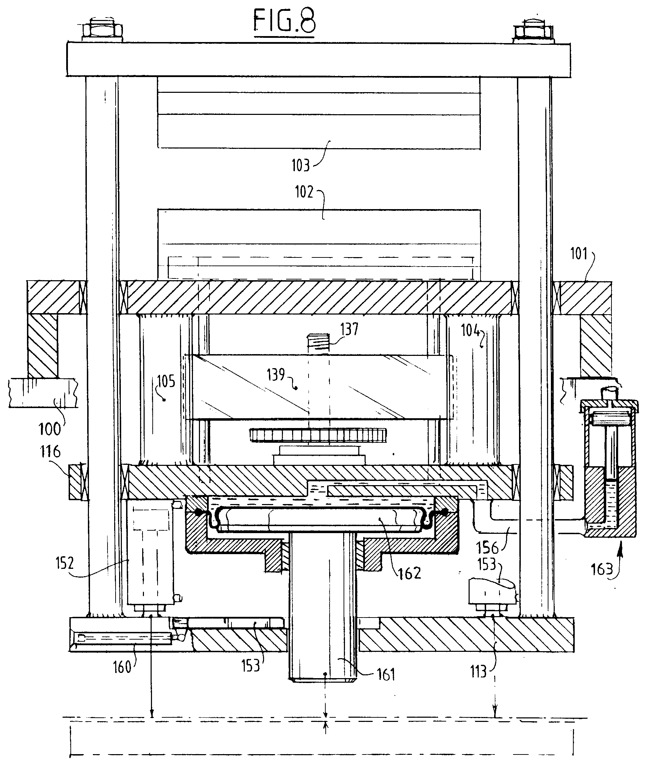

Figure 8 shows an alternative embodiment of the closing mechanism of the mould of the moulding apparatus according to the invention.

A discussion of those parts which correspond with the embodiment according to figure 7 is omitted.

The closing force of the mould halves is provided in this case by a piston-diaphragm cylinder unit filled with liquid. The plunger 161 is moved by the pressure of the liquid exerted on the piston 162, which is derived from the control cylinder 163. This is in contact with the cylinder space of the plunger 161 via the line 156.

Preferably a device 200 for measuring the closing force of one of the halves of the moulds is with respect to the other mould half is provided in the linkage for transferring the force from the electromotor to the movable mould half. Upon receiving a predetermined value of the closing force, a control signal is generated that is applied to stop the driving electromotor.

## Claims

1. Single-strip moulding apparatus comprising a mould formed by two mould halves movable relative to one another and closable onto one another, means for placing a leadframe into one of the mould halves, means for carrying moulding material into cavities of the mould, means for exerting pressure in these cavities, means for heating the mould halves, means for cleaning the mould halves and means for removing a moulded product from the mould, wherein the mould halves are closed relative to one another by an angle lever system connected to one of the mould halves and driven by an electromotor over a screwed rod.

2. Single-strip moulding apparatus comprising a mould formed by two mould halves movable relative to one another and closable onto one another, means for placing a leadframe into one of the mould halves, means for carrying moulding material into cavities of the mould, means for exerting pressure in these cavities, means for heating the mould halves, means for cleaning the mould halves and means for removing a moulded product from the mould, **characterized in that** the mould halves are moved relative to one another using a control mechanism consisting of at least one pneumatic cylinder and a closed piston-diaphragm cylinder unit filled with liquid for providing the closing force.

3. Apparatus as claimed in claim 1 or 2, **characterized in that** means (200) are provided for measuring the closing force of the mould halves.

4. Apparatus as claimed in claim 3, **characterized in that** said means (200) are adapted to produce a control signal to stop the electromotor for driving said angle lever system connected to one of the mould halves when said closure force obtains a predetermined value.
